# EUROPÄISCHE PATENTSCHRIFT

(11) **EP 3 837 556 B1**
(45) Veröffentlichungstag und Bekanntmachung des Hinweises auf die Patenterteilung: **13.12.2023**
(21) Anmeldenummer: 19756333.1
(22) Anmeldetag: 14.08.2019
(51) Int. Cl.: G01R 15/14, G01R 15/16, G01R 15/18, G01R 15/20

(54) **VORRICHTUNG ZUR MESSUNG VON STROMSTÄRKE UND SPANNUNG**
APPARATUS FOR MEASURING CURRENT INTENSITY AND VOLTAGE
DISPOSITIF DE MESURE D'INTENSITÉ DE COURANT ET DE TENSION

(30) Priorität: 16.08.2018 AT 506942018
(43) Veröffentlichungstag der Anmeldung: 23.06.2021
(73) Patentinhaber: Greenwood-Power GmbH, 2471 Rohrau (AT)
(72) Erfinder: JUSCHICZ, Norbert, 2404 Petronell-Carnuntum (AT); BACHER, Willibald, 2404 Petronell-Carnuntum (AT)
(74) Vertreter: Puchberger & Partner Patentanwälte
(86) Internationale Anmeldenummer: PCT/EP2019/071827
(87) Internationale Veröffentlichungsnummer: WO 2020/035533

(56) Entgegenhaltungen:
- EP-A1- 2 136 216
- EP-A1- 2 722 678
- EP-A1- 3 276 363
- CN-A- 103 076 481
- DE-A1- 19 854 436
- US-A- 4 241 373
- US-A- 5 017 859
- US-B2- 6 717 395

## Beschreibung

Die Erfindung betrifft eine Vorrichtung zur Messung von Stromstärke und Spannung in einem Wechselstrom führenden elektrischen Leiter gemäß dem Oberbegriff des unabhängigen Patentanspruchs.

Durch das vermehrte Einbringen von Energie aus verschiedenartigen Quellen, wie beispielsweise Solarenergie oder Windenergie, in Stromnetze, wird die Bestimmung und Überwachung von elektrischen Parametern des Stromnetzes immer wichtiger. Hierzu zählen unter anderem die Netzspannung und die Stromstärke.

Die Messung der Stromstärke erfolgt bei Wechselströmen, wie sie üblicherweise in Stromnetzen vorliegen mithilfe sogenannter Stromsensoren, auch als Stromwandler bezeichnet, die auf verschiedenen, im Stand der Technik bekannten Prinzipien beruhen können. Beispiele für derartige Stromsensoren sind etwa Rogowski-Spulen, Hall-Effekt-Sensoren oder induktive Stromwandler, welche mit oder ohne Shunt-Widerstand abgeschlossen sind.

Für die Messung der Spannung werden üblicherweise Spannungssensoren, auch als nicht konventionelle Spannungswandler bezeichnet, eingesetzt. Auch hier sind im Stand der Technik wiederum verschiedene Prinzipien bekannt, wie derartige Spannungswandler aufgebaut sein können. Insbesondere sind Spannungswandler mit kapazitiven Teilern, ohmschen Teilern und ohmsch-kapazitiven Teilern bekannt.

Um eine möglichst einfache Bestimmung der Stromstärke und Spannung in einem bestehenden Stromnetz durchführen zu können, werden im Stand der Technik oft Vorrichtungen eingesetzt, in denen sowohl ein Stromsensor als auch ein Spannungssensor verbaut sind. Hierdurch wird sowohl der apparative Aufwand minimiert, als auch die Installationskosten reduziert, da nur eine einzige Vorrichtung an der Messstelle installiert werden muss.

Im Stand der Technik sind bereits Vorrichtungen bekannt, in denen ein Stromwandler und ein Spannungswandler verbaut sind. Jedoch muss innerhalb dieser Vorrichtungen die Messleitung des Stromsensors an der Hochspannung des Spannungssensors vorbeigeführt werden muss. Die kapazitive Kopplung durch das elektrische Feld beeinträchtigt die Genauigkeit der Messung.

So geht aus der EP 3 276 363 A1 ein Plattenkondensator zur Strommessung hervor, dessen Achse mit der Achse des elektrischen Leiters zusammenfällt. Die US 5,017,859 A beschreibt ein Messgerät, das ein Spannungsmessgerät in einem Strommessgerät aufweist. Auch aus der EP 2 136 216 A1 und US 4,241,373 A gehen Strom- und Spannungsmessgeräte hervor, wobei das Strommessgerät durch eine ringförmige Spule gebildet wird.

Es ist also eine Aufgabe der Erfindung, eine Vorrichtung zur Messung von Stromstärke und Spannung bereitzustellen, die die oben angeführten Probleme minimiert oder überwindet.

Die Aufgabe der Erfindung wird durch die kennzeichnenden Merkmale des unabhängigen Patentanspruchs gelöst.

Die erfindungsgemäße Vorrichtung zur Messung von Stromstärke und Spannung in einem Wechselstrom führenden elektrischen Leiter umfasst einen induktiven Wechselstromsensor, welcher einen mit einer Messspule versehenen oder einen aus einer Messspule bestehenden Induktionsring umfasst, sowie einen Spannungssensor, welcher wenigstens ein kapazitives Element, insbesondere eine Kondensatoranordnung, und wenigstens ein resistives Element, nämlich eine Widerstandsanordnung umfasst.

Die Vorrichtung ist derart ausgeführt, dass der elektrische Leiter durch einen inneren Umfangsbereich des Induktionsrings führbar ist.

Erfindungsgemäß ist vorgesehen, dass der Stromsensor und der Spannungssensor vollständig in ein nichtleitendes Material, insbesondere in ein Gießharz, vorzugsweise in ein Epoxid-Gießharz, eingebettet sind, sodass das nichtleitende Material eine Sensorummantelung bildet. Einerseits kann dadurch die relative Position der einzelnen Elemente zueinander, also auch die Position der Verbindungsleitungen, insbesondere der Messleitungen, zueinander fixiert werden. Andererseits ist es durch das Einbetten der Sensoren in ein nichtleitendes Material möglich, die Sensoren besser gegen äußere Einflüsse zu schützen.

Ferner können durch die Wahl von geeigneten nichtleitenden Materialien temperaturund/oder feuchtigkeitsbedingte Schwankungen der Leistungsparameter der erfindungsgemäßen Vorrichtungen minimiert werden. Besonders bevorzugt ist hierbei die Verwendung eines Epoxid-basierten Gießharzes. Dieses weist üblicherweise eine geringe Wasserdurchlässigkeit bzw. geringe Wasseraufnahmefähigkeit auf.

Der induktive Wechselstromsensor kann auf verschiedenen im Stand der Technik bekannten Technologien beruhen. Beispielsweise kann es sich um einen Wechselstromsensor handeln, der aus einem von einer Messspule umwickelten Ringkern aufgebaut ist. Dabei kann der Ringkern insbesondere nur teilweise vom der Messspule umwickelt sein. Alternativ kann der Induktionsring auch durch die Messspule selbst gebildet werden, wie dies beispielsweise bei einer Rogowski-Spule der Fall ist. In diesem Fall ist kein Ringkern vorgesehen, es handelt sich also um einen kernlosen Stromwandler.

Auch der Spannungssensor kann auf verschiedenen Technologien basieren, beispielsweise kann es sich um einen ohmschen Spannungswandler, um einen kapazitiven Spannungswandler oder um einen ohmsch-kapazitiven Spannungswandler handeln. Im Fall des ohmschen Spannungswandlers ist eine Widerstandsanordnung vorgesehen, die zur Messung der Spannung eingesetzt wird. Üblicherweise umfasst die Widerstandsanordnung wenigstens zwei Widerstandselemente. Über die bekannten Widerstandsgrößen kann durch das Messen des Spannungsabfalls an den einzelnen Widerständen die Gesamtspannung bestimmt werden.

Im Fall der kapazitiven Spannungswandler ist eine Kondensatoranordnung vorgesehen, die zur Messung der Spannung eingesetzt wird. Üblicherweise umfasst die Kondensatoranordnung wenigstens zwei Kondensatorelemente. Über die bekannten Kapazitäten der Kondensatorelemente kann wiederum die Gesamtspannung bestimmt werden. Die Klasse der ohmsch-kapazitiven Spannungswandler stellt eine Mischform der beiden oben beschriebenen Arten dar und umfasst daher sowohl eine Kondensatoranordnung als auch eine Widerstandsanordnung, insbesondere wenigstens ein Kondensatorelement und wenigstens ein Widerstandselement.

Erfindungsgemäß ist vorgesehen, dass der Spannungssensor zumindest teilweise, vorzugsweise gänzlich im inneren Umfangsbereich des Induktionsrings angeordnet ist.

Durch die erfindungsgemäße Anordnung des Spannungssensors wird das Auftreten von Störungen, die durch Interferenzen der einzelnen Verbindungsleitungen bzw. Messleitungen hervorgerufen werden, minimiert.

Insbesondere wird dadurch erreicht, dass keine Leitung mit hoher elektrischer Wechselspannung in den Nahebereich von Messleitungen oder der Erdleitung geführt werden muss. Der Spannungssensor verbleibt gänzlich in unmittelbarer Nähe der zu messenden Leitung, sodass keine Interferenzen mit den Messleitungen auftreten. Insbesondere muss die Messleitung des Stromsensors nicht nahe an den hochspannungsführenden Komponenten des Spannungssensors vorbeigeführt werden. Auch wird die Gefahr einer Teilentladung minimiert, da die Hochspannungsleitung nicht in die Nähe des Erdpotentials oder die niederspannungsführende Messleitung des Stromsensors nicht nah zur Bauteilaußenfläche geführt wird. Zusätzlich können Erdpotenziale an der Bauteilaußenfläche auch zu Teilentladungen, sowie zu negativen Blitzstoßspannungstests (Typetests) führen. Darüber hinaus wird eine sehr kompakte Bauweise erreicht.

Gegebenenfalls kann also der Induktionsring derart ausgeführt sein, dass er in seinem inneren Umfangsbereich einen Aufnahmebereich für den Spannungssensor aufweist.

Vorteilhafterweise ist der innere Umfangsbereich derart ausgebildet, dass er den Spannungssensor in wenigstens einer seiner maximalen Außenabmessungen vollständig aufnehmen kann. Dabei sollte vorteilhafterweise gewährleistet sein, dass der Spannungssensor an keiner Stelle in elektrisch leitender Weise mit dem Stromsensor, insbesondere mit dem Induktionsring, in Verbindung steht.

Gegebenenfalls kann vorgesehen sein, dass der innere Umfangsbereich des Induktionsrings kreisförmig, elliptisch, oval oder langlochförmig ausgeführt ist. So kann gewährleistet werden, dass der innere Umfangsbereich des Induktionsrings den Spannungssensor aufnehmen kann.

Gegebenenfalls kann vorgesehen sein, dass der Spannungssensor mit einem Erdpotenzialanschluss sowie über ein Anschlussstück mit dem elektrischen Leiter verbindbar ist, wobei das Anschlussstück vorzugsweise gänzlich im inneren Umfangsbereich des Induktionsrings angeordnet ist.

Erfindungsgemäß ist vorgesehen, dass der Spannungssensor eine zylindrische Form aufweist, deren Zentralachse im inneren Umfangsbereich des Induktionsrings verläuft und vorzugsweise mit einer Symmetrieachse des Induktionsrings zusammenfällt.

Gegebenenfalls kann vorgesehen sein, dass der Durchmesser des Spannungssensors an seiner größten Stelle geringer ist als der Durchmesser des inneren Umfangsbereichs. Dadurch kann gewährleistet werden, dass der Spannungssensor wenigstens mit einer maximalen Raumabmessung, also insbesondere mit seinem Durchmesser, in den inneren Umfangsbereich des Induktionsrings einführbar ist.

Gegebenenfalls kann vorgesehen sein, dass eine, zwei, oder drei maximale Raumabmessungen, insbesondere maximale Außenabmessungen, des Spannungssensors kleiner sind, als eine, zwei oder drei minimale Raumabmessungen, insbesondere minimale Innenabmessungen, des inneren Umfangsbereichs der Induktionsspule.

Gegebenenfalls kann vorgesehen sein, dass im inneren Umfangsbereich des Induktionsrings eine Haltevorrichtung zur Halterung des Spannungssensors vorgesehen ist, wobei die Haltevorrichtung aus einem elektrischen Isolator, vorzugsweise aus Kunststoff, gebildet ist. Dadurch wird eine feste Positionierung des Spannungssensors ermöglicht, wobei der Spannungssensor trotzdem nicht in elektrisch leitender Weise mit dem Induktionsrind verbunden ist. Gegebenenfalls kann die Haltevorrichtung auch derart ausgebildet sein, um weitere Elemente der Vorrichtung halten zu können.

Gegebenenfalls kann vorgesehen sein, dass der von dem elektrischen Leiter geführte Strom eine Stromstärke zwischen 1 A und 3150 A aufweist.

Gegebenenfalls kann vorgesehen sein, dass die Potenzialdifferenz zwischen dem elektrischen Leiter und dem Erdpotenzialanschluss zwischen 0,72 kV und 50 kV beträgt.

Gegebenenfalls kann vorgesehen sein, dass der Induktionsring und/oder die Messspule nicht in elektrisch leitender Verbindung mit dem elektrischen Leiter stehen. In diesem Fall kann eine kontaktlose Strommessung erfolgen. Der vom elektrischen Leiter geführte Wechselstrom induziert beispielsweise im Induktionsring ein magnetisches Feld, welches in der Messspule einen Strom induziert. Gegebenenfalls kann der elektrische Leiter als im Wesentlichen gerader Leitungsabschnitt durch den Induktionsring führbar sein bzw. geführt sein.

Im Bereich der erfindungsgemäßen Anordnung ist der elektrische Leiter vorzugsweise als Primärleitungselement ausgebildet, das über Anschlusselemente mit der stromführenden Leitung verbunden ist. Das Primärleitungselement ist vorzugsweise jener Leitungsabschnitt, der durch den Induktionsring führbar bzw. geführt ist.

In einer bevorzugten Ausführungsform ist das Primärleitungselement gemeinsam mit dem Stromsensor und dem Spannungssensor in ein nichtleitendes Gießharz eingegossen. Dadurch wird die Position des Primärleiters in Bezug auf die Sensorelemente fixiert und die Messgenauigkeit verbessert. In diesem Fall ist das Primärleitungselement zumindest teilweise in das Gießharz eingebettet, sodass die Anschlusselemente zur Verbindung mit der Leitung freiliegen.

Gegebenenfalls kann vorgesehen sein, dass der Leiter gemeinsam mit Stromsensor und Spannungssensor zumindest teilweise in ein nichtleitendes Gießharz eingebettet ist.

Gegebenenfalls kann vorgesehen sein, dass der Stromsensor einen Shunt-Widerstand umfasst, der in elektrisch leitender Verbindung mit der Messspule und der Messeinrichtung steht, wobei der Shunt-Widerstand vorzugsweise an der Haltevorrichtung befestigt ist.

Ein derartiger Stromsensor, der eine Messspule und einen Shunt-Widerstand umfasst, ist besonders robust insbesondere gegen äußere Einflüsse und auch ökonomisch bevorzugt. Insbesondere kann der Shunt-Widerstand mit der Messspule parallel geschaltet sein.

Der Shunt-Widerstand kann insbesondere ein niederohmiger Widerstand sein, wobei von einer Messeinrichtung der vom Shunt-Widerstand hervorgerufene Spannungsabfall zur Bestimmung der Stromstärke eingesetzt werden kann. Insbesondere kann der Shunt-Widerstand also zur Bestimmung der Stromstärke eingesetzt werden, die durch den elektrischen Leiter in der Messspule induziert wurde. Vorteilhafterweise können derartige Shunt-Widerstände aufgrund ihres robusten Aufbaus auch zur Messung hoher Stromstärken eingesetzt werden. Bevorzugt fließen nur geringe Leistungen durch den Shunt-Widerstand. Im Fehlerfall, welche typischerweise für maximal drei Sekunden auftritt, können auch höhere Ströme durch den Shunt-Widerstand fließen.

Gegebenenfalls kann vorgesehen sein, dass der Stromsensor und der Spannungssensor in einem gemeinsamen Gehäuse angeordnet sind. Dadurch wird eine möglichst kompakte Bauweise und eine einfache Montage am Anwendungsort ermöglicht.

Gegebenenfalls kann vorgesehen sein, dass die Sensorummantelung von einer Außenummantelung umgeben ist, wobei die Außenummantelung vorzugsweise aus einem Siloxan-basierten Polymer gebildet ist. Eine Außenummantelung kann die Elemente der erfindungsgemäßen Vorrichtung mechanisch schützen und ebenfalls das Eindringen von Feuchtigkeit verhindern. Bevorzugt ist daher die Verwendung eines Siloxan-basierten Polymers, welches eine geringe Wasserdurchlässigkeit, sowie einen über einen weiten Temperaturbereich stabile Dielektrizitätskonstante aufweist.

Gegebenenfalls kann vorgesehen sein, dass die Außenummantelung die Vorrichtung umlaufende Rippen aufweist.

Gegebenenfalls kann vorgesehen sein, dass der Stromsensor und der Spannungssensor über voneinander getrennte Messleitungen mit einer Messeinrichtung verbunden sind. Gegebenenfalls kann vorgesehen sein, dass der Stromsensor und der Spannungssensor über eine gemeinsame Messleitung mit einer Messeinrichtung verbunden sind. In einer gemeinsamen Messleitung können bevorzugt mehrere voneinander isolierte elektrische Leiter vorliegen.

Die Erfindung betrifft weiterhin eine Anordnung einer erfindungsgemäßen Vorrichtung in einem elektrischen Leitungsnetz, insbesondere in einem Stromversorgungsnetz, umfassend einen elektrischen Leiter, der mit einer Leitung des elektrischen Leitungsnetzes verbunden ist, oder wobei der elektrische Leiter eine Leitung des elektrischen Leitungsnetzes ist.

Weitere erfindungsgemäße Merkmale ergeben sich aus den Figuren, dem Ausführungsbeispiel, sowie aus den Patentansprüchen.

Im Folgenden wird die Erfindung anhand eines exemplarischen Ausführungsbeispiels im Detail erläutert.

Das Ausführungsbeispiel dient der Veranschaulichung des Erfindungsgegenstandes und soll nicht den Schutzbereich der Ansprüche einschränken. Es zeigen:

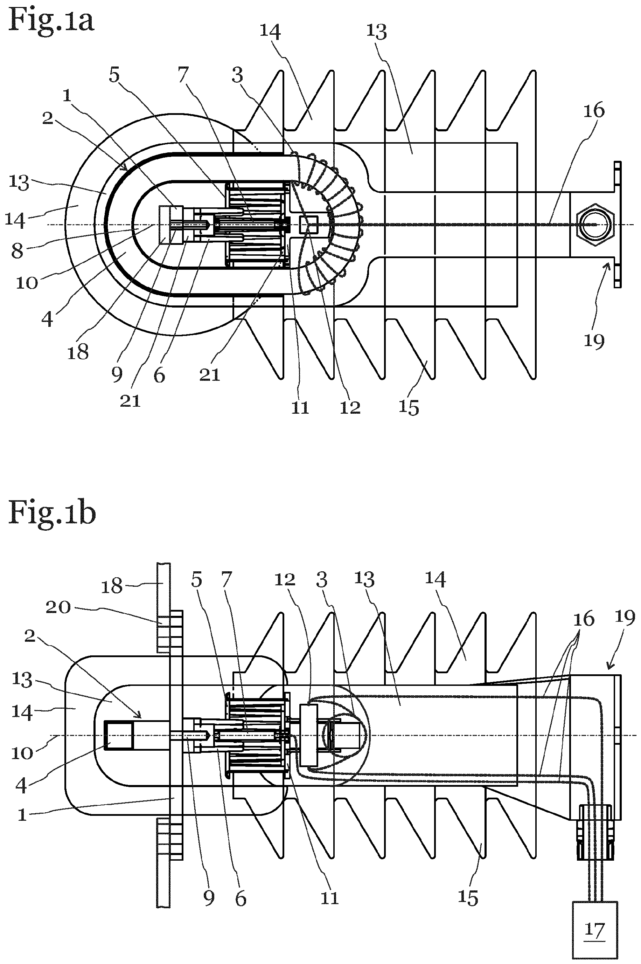

Fig. 1a: eine schematische Schnittansicht eines Ausführungsbeispiels der erfindungsgemäßen Vorrichtung;
Fig. 1 b: eine weitere schematische Schnittansicht des Ausführungsbeispiels der erfindungsgemäßen Vorrichtung.

Fig. 1a und Fig. 1b zeigen schematische Schnittansichten eines Ausführungsbeispiels der erfindungsgemäßen Vorrichtung, wobei der Stromsensor 2 und der Spannungssensor 5 in einer Sensorummantelung 13 eingebettet sind. Die Sensorummantelung 13 ist von einer Außenummantelung 14 umgeben, welche Rippen 15 aufweist, die die erfindungsgemäße Vorrichtung vollständig umlaufen.

Der Spannungssensor 5, der in diesem Ausführungsbeispiel als ohmsch-kapazitiver Spannungsteiler ausgebildet ist, umfasst eine Kondensatoranordnung 6, sowie eine Widerstandsanordnung 7. Die Kondensatoranordnung 6 ist aus zwei konzentrisch angeordneten Kondensatorteilen 21 aufgebaut. Die Widerstandsanordnung 7 wird durch einen im Zentrum der konzentrischen Kondensatorteile 21 angeordneten Widerstand gebildet. Insbesondere liegt also die Widerstandsanordnung 7 auf der Zentralachse 10 des zylindrisch aufgebauten Spannungssensors 5. Der Stromsensor 2 umfasst in diesem Ausführungsbeispiel einen mit einer Messspule 3 versehenen Induktionsring 4, sowie einen niederohmigen Shunt-Widerstand 12. Dabei bildet die Messspule 3 Wicklungen um den Induktionsring 4. Im vorliegenden Ausführungsbeispiel ist die Messspule 3 nur im unteren Abschnitt des Induktionsrings 4 angeordnet.

Der Induktionsring 4 weist einen inneren Umfangsbereich 8 auf, wobei der innere Umfangsbereich 8 in diesem Ausführungsbeispiel langlochförmig ausgebildet ist. Der Spannungssensor 5 ist innerhalb des inneren Umfangsbereichs 8 angeordnet. Die Abmessungen des inneren Umfangsbereichs 8 sind so gewählt, dass der Durchmesser des inneren Umfangsbereichs 8 größer ist als der Durchmesser des zylinderförmigen Spannungssensors 5. Weiterhin liegt in diesem Ausführungsbeispiel die Zentralachse 10 des Spannungssensors 5 auf einer Symmetrieachse des Induktionsrings 4.

Insbesondere ist in diesem Ausführungsbeispiel vorgesehen, dass zwei maximale Raumabmessungen des Spannungssensors 5 kleiner sind als die entsprechenden Raumabmessungen des inneren Umfangsbereichs 8 des Induktionsrings 4.

Um den Spannungssensor 5 korrekt und stabil im inneren Umfangsbereich 8 des Induktionsrings 4 zu platzieren, ist eine Haltevorrichtung 11 vorgesehen, die den Spannungssensor 5 mit dem Induktionsring 4 verbindet. Dabei ist die Haltevorrichtung 11 aus einem elektrisch isolierenden Material, insbesondere aus Kunststoff, gebildet, um keine elektrisch leitende Verbindung zwischen Stromsensor 2 und Spannungssensor 5 herzustellen. In diesem Ausführungsbeispiel ist die Haltevorrichtung 11 auch zur Halterung des Shunt-Widerstandes 12 vorgesehen.

Zum Abgreifen der Spannung ist der Spannungssensor 5 über ein Anschlussstück 9 mit einem elektrischen Leiter 1 verbunden, welcher seinerseits mit einer Leitung 18 verbunden ist, die in diesem Ausführungsbeispiel einen Teil eines Stromnetzes bildet. Der Spannungssensor 5 ist über eine Messleitung 16, welche mit einem Erdpotenzialanschluss 19 verbunden ist, mit einer Messeinrichtung 17 verbunden. Die Messeinrichtung 17 ist dazu eingerichtet, den durch die Kondensatoranordnung 6 und die Widerstandsanordnung 7 erzeugten Spannungsabfall zu messen und bei bekannter Kapazität der Kondensatoranordnung 6 sowie bekanntem ohmschen Widerstand der Widerstandsanordnung 7 die Spannung des elektrischen Leiters 1 im Vergleich zum Erdpotenzial zu bestimmen.

Die Messung der Stromstärke über den Stromsensor 2 erfolgt in diesem Ausführungsbeispiel kontaktlos. Der im Wesentlichen geradlinig verlaufende elektrische Leiter 1 wirkt als Primärspule mit einer einzigen Windung und induziert in den Induktionsring 4, welcher aus einem Ferrit-Ringkern gebildet ist, ein magnetisches Feld. Dieses magnetische Feld induziert wiederum in die als Sekundärspule wirkende Messspule 3 einen elektrischen Strom. Mit der Messspule 3 in Serie geschaltet ist der Shunt-Widerstand 12, welcher einen Spannungsabfall in der Messspule 3 bewirkt.

Zwei an beiden Seiten des Shunt-Widerstandes 12 angeordnete Messleitungen 16 verbinden den Shunt-Widerstand 12 mit der Messeinrichtung 17, welche dazu ausgebildet ist, den durch den Shunt-Widerstand 12 generierten Spannungsabfall zu bestimmen. Mithilfe des bekannten ohmschen Widerstandes des Shunt-Widerstandes 12 kann die Stromstärke in der Messspule 3 bestimmt werden, welche indirekt proportional über das Windungsverhältnis zwischen Primärspule, also dem elektrischen Leiter 1, und Sekundärspule, also der Messspule 3, mit der Stromstärke im elektrischen Leiter 1 zusammenhängt.

Die Messeinrichtung 17 muss also dazu geeignet sein, den Spannungsabfall zwischen Spannungssensor 5 und Erdpotenzialanschluss 19, sowie den Spannungsabfall am Shunt-Widerstand 12 zu bestimmen. Die Messeinrichtung 17 kann die beiden Messgrößen vorzugsweise simultan bestimmen, wobei die Messeinrichtung 17 auch als zwei separate Messeinrichtungen 17 ausgebildet sein kann. Zur besseren Darstellbarkeit ist die Messeinrichtung 17 in Fig. 1a nicht gezeigt. Gegebenenfalls kann eine Rechnereinheit vorgesehen sein, die die gemessenen Spannungsabfälle in Spannung und Stromstärke umrechnet. Die Rechnereinheit ist in den gezeigten Figuren nicht dargestellt.

In diesem Ausführungsbeispiel sind sowohl der Stromsensor 2 als auch der Spannungssensor 5 von einer Sensorummantelung 13 umgeben, welche aus Epoxid-Gießharz gebildet ist. Dadurch werden der Stromsensor 2 und des Spannungssensor 5 in ihrer relativen Position zueinander stabilisiert und das Risiko ungewollter Spannungsüberschläge wird minimiert. Weiters kann durch die Verwendung von Epoxid-Gießharz gewährleistet werden, dass die Sensorummantelung 13 nur wenig Wasser in Form von Luftfeuchte oder Regenwasser aufnehmen kann, was die Messgenauigkeit der Vorrichtung reduzieren könnte.

In diesem Ausführungsbeispiel schließt die Sensorummantelung 13 nicht nur den Stromsensor 2 und den Spannungssensor 5 ein, sondern auch große Teile der Messleitungen 16, die die Sensoren mit der Messeinrichtung 17 verbinden.

Zusätzlich ist in diesem Ausführungsbeispiel eine Außenummantelung 14 vorgesehen, die aus Siloxan-basiertem Gießharz hergestellt ist. Diese Außenummantelung 14 dient einer weiteren Verbesserung der Beständigkeitseigenschaften der erfindungsgemäßen Vorrichtung, indem das Eindringen von Wasser weiter hintangehalten wird.

Wie in Fig. 1b erkennbar, ist der elektrische Leiter 1 über Anschlusselemente 20 mit zwei Leitungen 18 verbunden, die einen Teil des Stromnetzes bilden.

Die Erfindung beschränkt sich nicht auf das vorliegende Ausführungsbeispiel, sondern umfasst sämtliche Vorrichtungen und Anordnungen im Rahmen der nachfolgenden Patentansprüche.

### Bezugszeichenliste

- 1: Elektrischer Leiter
- 2: Stromsensor
- 3: Messspule
- 4: Induktionsring
- 5: Spannungssensor
- 6: Kondensatoranordnung
- 7: Widerstandsanordnung
- 8: Innerer Umfangsbereich
- 9: Anschlussstück
- 10: Zentralachse
- 11: Haltevorrichtung
- 12: Shunt-Widerstand
- 13: Sensorummantelung
- 14: Außenummantelung
- 15: Rippe
- 16: Messleitung
- 17: Messeinrichtung
- 18: Leitung
- 19: Erdpotenzialanschluss
- 20: Anschlusselement
- 21: Kondensatorteil

## Patentansprüche

1. **Vorrichtung** zur Messung von Stromstärke und Spannung in einem Wechselstrom führenden elektrischen Leiter (1), umfassend:
a. einen induktiven Wechselstromsensor (2), welcher einen mit einer Messspule (3) versehenen oder einen aus einer Messspule (3) bestehenden Induktionsring (4) umfasst, und
b. einen Spannungssensor (5), welcher wenigstens ein kapazitives Element, insbesondere eine Kondensatoranordnung (6) umfasst,
wobei die Vorrichtung derart ausgeführt ist, dass der elektrische Leiter (1) durch einen inneren Umfangsbereich (8) des Induktionsrings (4) führbar ist,
wobei der Spannungssensor (5) zumindest teilweise, vorzugsweise gänzlich im inneren Umfangsbereich (8) des Induktionsrings (4) angeordnet ist,
wobei der Stromsensor (2) und der Spannungssensor (5) vollständig in ein nichtleitendes Gießharz, vorzugsweise in ein Epoxid-Gießharz, eingebettet sind, sodass das nichtleitende Gießharz eine Sensorummantelung (13) bildet,
**dadurch gekennzeichnet, dass**
c. der Spannungssensor (5) eine Widerstandsanordnung (7) umfasst und
d. eine zylindrische Form aufweist, deren Zentralachse (10) im inneren Umfangsbereich (8) des Induktionsrings (4) verläuft und mit einer Symmetrieachse des Induktionsrings (4) zusammenfällt, und wobei
e. die Widerstandsanordnung (7) auf der Zentralachse (10) des Spannungssensors (5) liegt.

2. Vorrichtung nach Anspruch 1, **dadurch gekennzeichnet, dass** der innere Umfangsbereich (8) des Induktionsrings (4) kreisförmig, elliptisch, oval oder langlochförmig ausgeführt ist.

3. Vorrichtung nach Anspruch 1 oder 2, **dadurch gekennzeichnet, dass** der Spannungssensor (5) mit einem Erdpotenzialanschluss (19) sowie über ein Anschlussstück (9) mit dem elektrischen Leiter (1) verbindbar ist, wobei das Anschlussstück (9) vorzugsweise gänzlich im inneren Umfangsbereich (8) des Induktionsrings (4) angeordnet ist.

4. Vorrichtung nach einem der Ansprüche 1 bis 3, **dadurch gekennzeichnet, dass** der Durchmesser des Spannungssensors (5) an seiner größten Stelle geringer ist als der Durchmesser des inneren Umfangsbereichs (8).

5. Vorrichtung nach einem der Ansprüche 1 bis 4, **dadurch gekennzeichnet, dass** im inneren Umfangsbereich (8) des Induktionsrings (4) eine Haltevorrichtung (11) zur Halterung des Spannungssensors (5) vorgesehen ist, wobei die Haltevorrichtung (11) aus einem elektrischen Isolator, vorzugsweise aus Kunststoff, gebildet ist.

6. Vorrichtung nach einem der Ansprüche 1 bis 5, wobei die Vorrichtung so ausgestaltet ist, dass sie geeignet ist, einen vom elektrischen Leiter (1) geführten Strom einer Stromstärke zwischen 1 A und 3150 A zu messen.

7. Vorrichtung nach Anspruch 3, wobei die Vorrichtung für eine Potentialdifferenz zwischen dem elektrischen Leiter (1) und dem Erdpotentialanschluss (19) zwischen 0,72 kV und 50 kV ausgestaltet ist.

8. Vorrichtung nach einem der Ansprüche 1 bis 7, **dadurch gekennzeichnet, dass** der Induktionsring (4) und/oder die Messspule (3) nicht in elektrisch leitender Verbindung mit dem elektrischen Leiter (1) stehen.

9. Vorrichtung nach einem der Ansprüche 1 bis 8, **dadurch gekennzeichnet, dass** der Stromsensor einen Shunt-Widerstand (12) umfasst, der in elektrisch leitender Verbindung mit der Messspule (3) und der Messeinrichtung (17) steht, wobei der Shunt-Widerstand (12) vorzugsweise an der Haltevorrichtung (11) befestigt ist.

10. Vorrichtung nach einem der Ansprüche 1 bis 9, **dadurch gekennzeichnet, dass** der Stromsensor und der Spannungssensor in einem gemeinsamen Gehäuse angeordnet sind.

11. Vorrichtung nach Anspruch 10, **dadurch gekennzeichnet, dass** die Sensorummantelung (13) von einer Außenummantelung (14) umgeben ist, wobei die Außenummantelung (14) vorzugsweise aus einem Siloxan-basierten Polymer gebildet ist.

12. Vorrichtung nach Anspruch 11, **dadurch gekennzeichnet, dass** die Außenummantelung (14) die Vorrichtung umlaufende Rippen (15) aufweist.

13. Vorrichtung nach einem der Ansprüche 1 bis 12, **dadurch gekennzeichnet, dass** der Stromsensor (2) und der Spannungssensor (5) über eine gemeinsame Messleitung (16) mit einer Messeinrichtung (17) verbunden ist.

14. Verwendung einer Vorrichtung nach einem der Ansprüche 1 bis 13 zur Anordnung in einem elektrischen Leitungsnetz, insbesondere in einem Stromversorgungsnetz, umfassend einen elektrischen Leiter (1), der mit einer Leitung (18) des elektrischen Leitungsnetzes verbunden ist, oder wobei der elektrische Leiter (1) eine Leitung des elektrischen Leitungsnetzes ist.

## Claims

1. A device for measuring current intensity and voltage in an electrical conductor (1) conducting alternating current, comprising:
a. an inductive alternating current sensor (2) comprising an induction ring (4) provided with or consisting of a measuring coil (3), and
b. a voltage sensor (5) comprising at least one capacitive element, in particular a capacitor arrangement (6),
wherein the device is designed in such a way that the electrical conductor (1) is guidable through an inner peripheral region (8) of the induction ring (4), wherein the voltage sensor (5) is arranged at least partially, preferably entirely, in the inner peripheral region (8) of the induction ring (4), wherein the current sensor (2) and the voltage sensor (5) are completely embedded in a non-conductive casting resin, preferably in an epoxy casting resin, so that the non-conductive casting resin forms a sensor sheath (13),
**characterised in that**
c. the voltage sensor (5) comprises a resistor arrangement (7) and
d. has a cylindrical shape whose central axis (10) extends in the inner peripheral region (8) of the induction ring (4) and coincides with an axis of symmetry of the induction ring (4), and wherein
e. the resistor arrangement (7) lies on the central axis (10) of the voltage sensor (5).

2. The device according to claim 1, **characterised in that** the inner peripheral region (8) of the induction ring (4) is circular, elliptical, oval or elongated hole-shaped.

3. The device according to claim 1 or 2, **characterised in that** the voltage sensor (5) is connectable to an ground potential terminal (19) and to the electrical conductor (1) via a connector (9), the connector (9) preferably being arranged entirely in the inner peripheral region (8) of the induction ring (4).

4. The device according to any one of claims 1 to 3, **characterised in that** the diameter of the voltage sensor (5) at its largest point is smaller than the diameter of the inner peripheral region (8).

5. The device according to any one of claims 1 to 4, **characterised in that** a holding device (11) for holding the voltage sensor (5) is provided in the inner peripheral region (8) of the induction ring (4), the holding device (11) being formed of an electrical insulator, preferably made of plastic.

6. The device of any one of claims 1 to 5, wherein the device is configured to be suitable for measuring a current, conducted by the electrical conductor (1), of between 1 A and 3150 A.

7. The device according to claim 3, wherein the device is designed for a potential difference between the electrical conductor (1) and the ground potential terminal (19) between 0.72 kV and 50 kV.

8. The device according to any one of claims 1 to 7, **characterised in that** the induction ring (4) and/or the measuring coil (3) are not in electrically conductive connection with the electrical conductor (1).

9. The device according to any one of claims 1 to 8, **characterised in that** the current sensor comprises a shunt resistor (12) which is in electrically conductive connection with the measuring coil (3) and the measuring device (17), wherein the shunt resistor (12) is preferably attached to the holding device (11).

10. The device according to any one of claims 1 to 9, **characterised in that** the current sensor and the voltage sensor are arranged in a mutual casing.

11. The device according to claim 10, **characterised in that** the sensor sheath (13) is surrounded by an outer sheath (14), the outer sheath (14) preferably being formed of a siloxane-based polymer.

12. The device according to claim 11, **characterised in that** the outer casing (14) has ribs (15) surrounding the device.

13. The device according to any one of claims 1 to 12, **characterised in that** the current sensor (2) and the voltage sensor (5) are connected to a measuring device (17) via a mutual measuring line (16).

14. A use of the device according to any one of claims 1 to 13, for arrangement in an electrical line network, in particular in a power supply network, comprising an electrical conductor (1) connected to a line (18) of the electrical line network, or wherein the electrical conductor (1) is a line of the electrical line network.

## Revendications

1. **Dispositif** de mesure de l'intensité du courant et de la tension dans un conducteur électrique (1) conduisant un courant alternatif, comprenant :
a. un capteur inductif de courant alternatif (2), qui comprend un anneau d'induction (4) pourvu d'une bobine de mesure (3) ou constitué d'une bobine de mesure (3), et
b. un capteur de tension (5), qui comprend au moins un élément capacitif, en particulier un agencement de condensateur (6),
dans lequel le dispositif est réalisé de telle sorte que le conducteur électrique (1) est guidable à travers une zone périphérique intérieure (8) de l'anneau d'induction (4), le capteur de tension (5) étant disposé au moins partiellement, de préférence entièrement, dans la zone périphérique intérieure (8) de l'anneau d'induction (4), le capteur de courant (2) et le capteur de tension (5) étant entièrement noyés dans une résine de coulée non conductrice, de préférence dans une résine de coulée époxy, de sorte que la résine de coulée non conductrice forme une enveloppe de capteur (13),
**caractérisé en ce que**
c. le capteur de tension (5) comprend un agencement de résistance (7) et
d. a une forme cylindrique dont l'axe central (10) s'étend dans la zone périphérique intérieure (8) de l'anneau d'induction (4) et coïncide avec un axe de symétrie de l'anneau d'induction (4), et dans lequel
e. l'agencement de résistance (7) se trouve sur l'axe central (10) du capteur de tension (5).

2. Dispositif selon la revendication 1, **caractérisé en ce que** la zone périphérique intérieure (8) de l'anneau d'induction (4) est de forme circulaire, elliptique, ovale ou en forme de trou oblong.

3. Dispositif selon la revendication 1 ou 2, **caractérisé en ce que** le capteur de tension (5) est raccordable à une borne de potentiel de terre (19) ainsi qu'au conducteur électrique (1) par l'intermédiaire d'une pièce de raccordement (9), la pièce de raccordement (9) étant de préférence entièrement disposée dans la zone périphérique intérieure (8) de l'anneau d'induction (4).

4. Dispositif selon l'une des revendications 1 à 3, **caractérisé en ce que** le diamètre du capteur de tension (5) à son point le plus grand est inférieur au diamètre de la zone périphérique intérieure (8).

5. Dispositif selon l'une des revendications 1 à 4, **caractérisé en ce que** dans la zone périphérique intérieure (8) de l'anneau d'induction (4) est prévu un dispositif de retenue (11) pour retenir le capteur de tension (5), le dispositif de retenue (11) étant formé d'un isolant électrique, de préférence en matière plastique.

6. Dispositif selon l'une des revendications 1 à 5, le dispositif étant configuré pour être apte à mesurer un courant d'intensité, conduit par le conducteur électrique (1), compris entre 1 A et 3150 A.

7. Dispositif selon la revendication 3, dans lequel le dispositif est configuré pour une différence de potentiel entre le conducteur électrique (1) et la borne de potentiel de terre (19) comprise entre 0,72 kV et 50 kV.

8. Dispositif selon l'une des revendications 1 à 7, **caractérisé en ce que** l'anneau d'induction (4) et/ou la bobine de mesure (3) ne sont pas en communication électriquement conductrice avec le conducteur électrique (1).

9. Dispositif selon l'une des revendications 1 à 8, **caractérisé en ce que** le capteur de courant comprend une résistance de shunt (12) qui est en communication électriquement conductrice avec la bobine de mesure (3) et le dispositif de mesure (17), la résistance de shunt (12) étant de préférence fixée sur le dispositif de retenue (11).

10. Dispositif selon l'une des revendications 1 à 9, **caractérisé en ce que** le capteur de courant et le capteur de tension sont disposés dans un boîtier commun.

11. Dispositif selon la revendication 10, **caractérisé en ce que** l'enveloppe de capteur (13) est entourée par une enveloppe extérieure (14), l'enveloppe extérieure (14) étant de préférence formée d'un polymère à base de siloxane.

12. Dispositif selon la revendication 11, **caractérisé en ce que** l'enveloppe extérieure (14) présente des nervures (15) entourant le dispositif.

13. Dispositif selon l'une des revendications 1 à 12, **caractérisé en ce que** le capteur de courant (2) et le capteur de tension (5) sont connectés à une unité de mesure (17) par une ligne de mesure (16) commune.

14. Utilisation d'un dispositif selon l'une des revendications 1 à 13, destiné à être disposé dans un réseau de lignes électriques, en particulier dans un réseau d'alimentation électrique, comprenant un conducteur électrique (1) qui est connecté à une ligne (18) du réseau de lignes électriques, ou dans laquelle le conducteur électrique (1) est une ligne du réseau de lignes électriques.
